## Europäisches Patentamt

## European Patent Office

## Office européen des brevets

(19)

(11) Veröffentlichungsnummer: **0 011 713**
**B2**

(12) **NEUE EUROPÄISCHE PATENTSCHRIFT**

(45) Veröffentlichungstag der neuen Patentschrift:
**02.04.86**

(21) Anmeldenummer: **79104151.0**

(22) Anmeldetag: **26.10.79**

(51) Int. Cl.⁴: **G 10 K  9/13,** G 08 B  3/10,
H 03 B  23/00

---

(54) **Akustischer Signalgeber mit periodisch sich ändernder Frequenz des Ausgangssignals.**

---

(30) Priorität: **02.12.78  DE 2852196**

(43) Veröffentlichungstag der Anmeldung:
**11.06.80 Patentblatt 80/12**

(45) Bekanntmachung des Hinweises auf die Patenterteilung:
**26.01.83 Patentblatt 83/4**

(45) Bekanntmachung des Hinweises auf die Entscheidung
über den Einspruch:
**02.04.86 Patentblatt 86/14**

(84) Benannte Vertragsstaaten:
**FR GB IT NL**

(73) Patentinhaber: **Richard Hirschmann Radiotechnisches
Werk, Richard-Hirschmann-Strasse 19, D-7300 Esslingen
a.N. (DE)**

(72) Erfinder: **Siegwarth, Martin, Ing.(grad.), Hölderlinweg 33,
D-7300 Esslingen a.N. (DE)**

(74) Vertreter: **Stadler, Heinz, Dipl.-Ing., Richard Hirschmann
Radiotechnisches Werk
Richard-Hirschmann-Strasse 19, D-7300 Esslingen a.N.
(DE)**

(56) Entgegenhaltungen:
**DE - A - 1 566 952
DE - A - 1 566 953
DE - A - 2 019 154
DE - A - 2 229 167
DE - A - 2 554 219
DE - A - 2 554 940
DE - B - 1 140 970
DE - B - 2 601 922
DE - C - 1 150 008
DE - U - 6 605 465
US - A - 3 137 846
US - A - 3 810 169**

**Beschreibung**

Akustische Signalgeber nach dem Oberbegriff des Anspruches 1 sind sowohl aus der Praxis, zum Beispiel von Alarm- und Werkssirenen, in vielen Variationen bekannt, als auch druckschriftlich, z.B. aus der DE-PS-1 566 953. Sie weisen durchwegs zwei Oszillatoren auf, von denen einer das Tonfrequenzsignal und der andere das zum Wobbeln benötigte Niederfrequenzsignal erzeugt, wobei im Falle der aus der DE-PS-1 566 953 bekannten Schaltung dem Wobbeloszillator digitale Frequenzteiler nachgeschaltet sind.

Derartige Signalgeber weisen eine Reihe schwerwiegender Nachteile auf, die zum einen hohe Herstellkosten, vor allem bedingt durch den Wobbelfrequenz-Oszillator, für den grosse und teuere Kondensatoren benötigt werden, und zum anderen eine starke Beeinträchtigung ihres Nutzungswertes zur Folge haben. Mit dem zuletzt genannten Punkt ist die Eigenschaft angesprochen, dass identisch aufgebaute Signalgeber in ihren akustischen Kennwerten so weit voneinander abweichen können, dass ihre praktische Verwendbarkeit in Frage gestellt, ja in vielen Fällen in untragbarem Masse eingeschränkt ist. Diesem Mangel der bekannten Signalgeber kommt eine besonders weittragende Bedeutung zu, weil er durch Streuungen der Bauteilewerte verursacht ist, die im Rahmen der gewählten Toleranzen unvermeidbar sind. Im einzelnen ergeben sich daraus Unterschiede der Ausgangssignale bzgl. Frequenz und Impulsbreite und somit auch des Tastverhältnisses. Dabei weicht die Impulsbreite nach oben oder unten vom Sollwert ab, wodurch entweder die Lautstärke zu gering ist, da die Lautsprechermembrane nicht zum Vollausschlag kommt, oder aber ungenutzte Leistung verbraucht wird, wenn der Strom länger fliesst, als die Membrane zum Vollausschlag benötigt.

Ausserdem haben die voneinander abweichenden Werte des Tastverhältnisses einen unterschiedlichen Oberwellengehalt der Ausgangssignale und damit in aller Regel Klangdifferenzen bei gleich aufgebauten Signalgebern zur Folge.

Der Erfindung liegt die Aufgabe zugrunde, einen Signalgeber gemäss Oberbegriff des Anspruches 1 zu schaffen, der in Aufbau und Herstellung möglichst einfach und kostengünstig ist und bei dem die akustischen Kennwerte des Ausgangssignals weitestgehend unabhängig von Bauteilestreuungen sind.

Diese Aufgabe wird erfindungsgemäss dadurch gelöst, dass zum Erzeugen des Ausgangssignals nur ein einziger Oszillator vorgesehen ist, dessen Grundsignal durch ein aus diesem mittels digitaler Frequenzteiler gewonnenes niederfrequentes Wobbelsignal veränderbar ist. Dabei ist selbstverständlich die Oszillatorgrundfrequenz mindestens so gross wie die gewünschte Tonfrequenz (im Regelfall zwischen 400 und 500 Hz); die Anzahl der Frequenzteiler ergibt sich dann unter Berücksichtigung der Tatsache, dass Flip-Flops als Binärteiler nur durch den Faktor zwei teilen, ohne weiteres aus der gewünschten Wobbelfrequenz, die vorzugsweise zwischen einem und drei Hz beträgt.

Ein derartiger Signalgeber ist kostensparend aufgebaut, weil der bei herkömmlichen Geräten dieser Art benötigte Wobbeloszillator mit teueren Kondensatoren entfällt und die statt dessen verwendeten Frequenzteiler als billige IC's im Handel fertig erhätlich sind. Ausserdem sind die beschriebenen Abweichungen der akustischen Kennwerte von Signalgebern mit dem gleichen Aufbau bereits wesentlich vermindert, da das Verhältnis von Oszillator- und Grundfrequenz zu Wobbelfrequenz wegen der digitalen Frequenzteiler unabhängig von Bauteilestreuungen konstant ist.

In den Unteransprüchen sind vorteilhafte Ausgestaltungen des Gegenstandes nach dem Hauptanspruch beschrieben. Die Einkopplung des Wobbelsignals über einen Transistor auf die in Anspruch 2 beschriebene Art ermöglicht es auf einfache und elegante Weise, als Schwingungserzeuger einen Digitaloszillator zu verwenden. Diese im einfachsten Fall aus einem als preiswerten IC erhältlichen Inverter, einem Kondensator und einem frequenzbestimmenden Widerstand aufgebauten Geräte sind vor allem auch dauerhaft sicher in der Funktion, was gerade für Alarmanlagen, in denen ja akustische Signalgeber vorzugsweise eingesetzt sind, besonders wichtig ist.

Bei einer Ausführung der Signalgeberschaltung nach Anspruch 3 sind in vorteilhafter Weise der Eingang des ersten, gegebenenfalls einzigen Inverters durch einen Schutzwiderstand und der Transistor mittels einer Diode geschützt, die verhindert, dass der Emitter des Transistors positiver wird als der Kollektor.

Mit Hilfe eines Parallelwiderstandes gemäss Anspruch 4 ist ein einfacher Abgleich des frequenzbestimmenden Widerstandes und damit der gewünschten Oszillatorgrundfrequenz ermöglicht. Diese Methode ist zudem kostengünstiger als die Verwendung eines Potentiometers.

Durch die Wahl der Anzahl und Grösse der Widerstände, sowie der Verbindungsstellen, an denen diese angeschlossen werden, lassen sich beinahe beliebige Verläufe des Wobbel-Signals (Kollektorstrom des Transistors) erzeugen. Bei Verwendung nur eines Widerstandes wie bei dem Signalgeber nach Anspruch 2, ergibt sich das zum Beispiel von den Signalgebern der Polizei (Martinshorn) her bekannte ta-tü-ta-tü, welches lediglich zwei Frequenzen aufweist. Eine Ausführung des erfindungsgemässen Signalgebers nach Anspruch 5 ergibt demgegenüber eine sehr einprägsame stufenweise Stromänderung, wobei der Verlauf dieses Treppenstroms umso kontinuierlicher, das heisst die Stufenzahl der Treppe umso grösser ist, je mehr Widerstände eingeschaltet sind. Bei n Widerständen hat die Treppe $2^n$ Stufen. Linear steigt die Treppe dann an, wenn die Widerstände vom Ende der Teilerkette aus betrachtet im Verhältnis 1:2:4:8 usw. ansteigen.

Diese Beschreibung des Treppenstromverlaufs ist allerdings nicht völlig exakt. Genaugenommen werden die Stufenbreiten mit zunehmender Frequenz bzw. wachsendem Kollektorstrom geringer, so dass der Treppenstrom etwa nach Art einer e-Funktion ansteigt. Dies ist darauf zurückzuführen, dass zur Erzeugung des Wobbelsignals kein Signal konstanter Frequenz in die Teilerkette eingespeist wird, sondern bereits das gewobbelte Signal. Für die Signalwirkung bedeutet diese jedoch keinen Nachteil, vielmehr ist das resultierende Signal in vorteilhafter Weise besonders auffällig. Wählt man anstatt eines npn- einen pnp-Transistor und vertauscht die Anschlüsse der Schutzdiode, so ergibt sich anstatt des ansteigenden ein abfallender Treppenstromverlauf. Die Signalwirkung ist dabei jedoch erfahrungsgemäss bedeutend geringer.

Die Schaltung mit nur einer Schutzdiode funktioniert in der Praxis auch bei Verwendung mehrer Widerstände zur Erzeugung eines treppenförmigen Wobbelsignals hinreichend gut. Noch besser ist es indessen, wenn entsprechend Anspruch 6 in Serie zu jedem der Widerstände eine Diode geschaltet und dadurch neben dem Schutz des Transistors auch gewährleistet ist, dass der gesamte Strom aus den Widerständen zum Kollektor des Transistors fliesst.

Die Zusammenfassung mehrerer Tonfrequenzsignale nach Anspruch 7 mittels eines Und-Gatters stellt eine im Hinblick auf die Aufgabenstellung besonders zweckmässige und dennoch einfache und dauerhaft sicher funktionierende Methode dar, das Tastverhältnis des Ausgangssignals dem gewünschten Wert anzupassen.

Bei vorzugsweiser Zusammenfassung dreier, jeweils nur durch einen Frequenzteiler getrennter Signale ergibt sich ein Tastverhältnis von 1:7, welches bei Verwendung einer Tonfrequenz von etwa 400 Hz bezüglich der Aussteuerung des Lautsprechers einen optimalen Kompromiss zwischen ungenützt verbrauchter Leistung und nicht vollem Membranausschlag darstellt. Dieses Tastverhältnis des Ausgangssignals ist wegen der binären Teiler, die bekanntermassen nur zwei Zustände aufweisen können, zwangsläufig fest und damit unabhängig von Bauteilestreuungen.

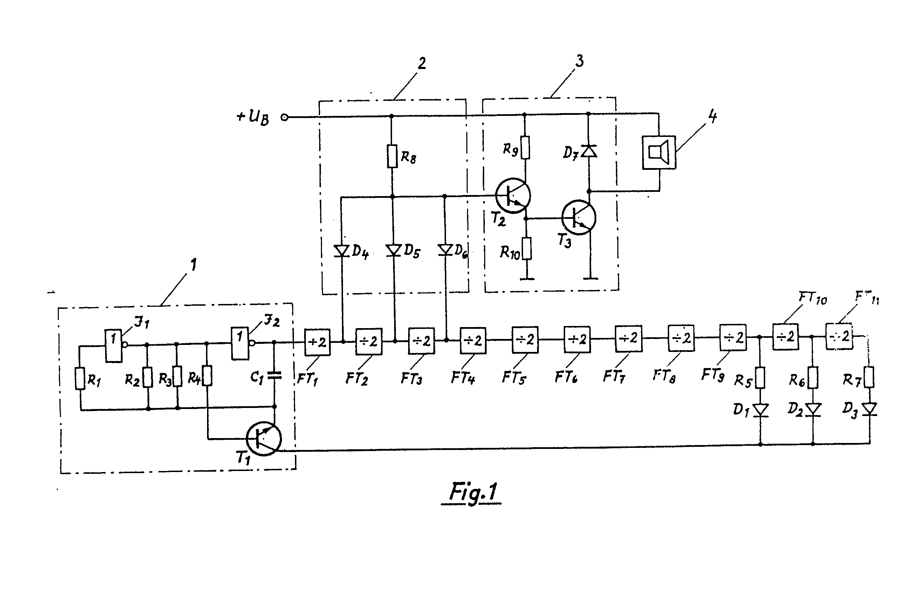

Die Figuren zeigen das Schaltbild (Figur 1) eines Ausführungsbeispieles des erfindungsgemässen Signalgebers, sowie zwei Diagramme, in denen die Zusammensetzung des Wobbel-Signales, d.h. des Kollektorstroms des Oszillatortransistors (Figur 2), sowie des Tonfrequenzsignals am Ausgang des Und-Gatters (Figur 3) dargestellt ist.

Der Oszillator 1 weist einen an sich bekannten, für sich alleine funktionsfähigen Digitaloszillator auf, der aus zwei Invertern $I_1$ und $I_2$, einem dazwischen angeschlossenen frequenzbestimmenden Widerstand $R_2$, einem dazu parallel geschalteten Abgleichwiderstand $R_3$, einem am Eingang des ersten Inverters $I_1$ angeschlossenen Schutzwiderstand $R_1$, sowie einem mit dem Ausgang des zweiten Inverters $I_2$ verbundenen Kondensator $C_1$ besteht, wobei die jeweils anderen Enden der Widerstände $R_1$, $R_2$ und $R_3$, sowie des Kondensators $C_1$ zusammengeschaltet sind. Dieser

äusserst einfache und zuverlässige Oszillator funktioniert auf folgende Weise:

Wenn am Eingang des ersten Inverters $I_1$ ein Potential H (High) anliegt, besteht an seinem Ausgang und damit am Eingang des zweiten Inverters $I_2$ ein L (Low) und an dessen Ausgang wiederum ein H. Dabei fliesst über die Widerstände $R_2$ parallel $R_3$ ein Strom, der den Kondensator $C_1$ entlädt. Dadurch sinkt das Potential des Kondensators $C_1$ an der dem zweiten Inverter $I_2$ abgewandten Elektrode und damit am Eingang des ersten Inverters $I_1$ und damit der Eingang des zweiten Inverters $I_2$ liegt auf H, der Ausgang des letzteren auf L. Der Kondensator wird nunmehr aufgeladen und der beschriebene Vorgang verlauft umgekehrt. Damit entsteht auf ebenso einfache wie zuverlässige Weise ein Rechtecksignal, dessen Frequenz im vorliegenden Ausführungsbeispiel 3,072 kHz beträgt.

Dieses Oszillatorgrundsignal soll nun gemäss Anspruch 1 durch ein Wobbel-Signal veränderbar sein. Dabei ergibt sich jedoch das Problem, dass bei dem beschriebenen Einfachstoszillator der frequenzbestimmende Widerstand $R_2$ parallel $R_3$ nicht ohne weiteres direkt elektrisch steuerbar ist.

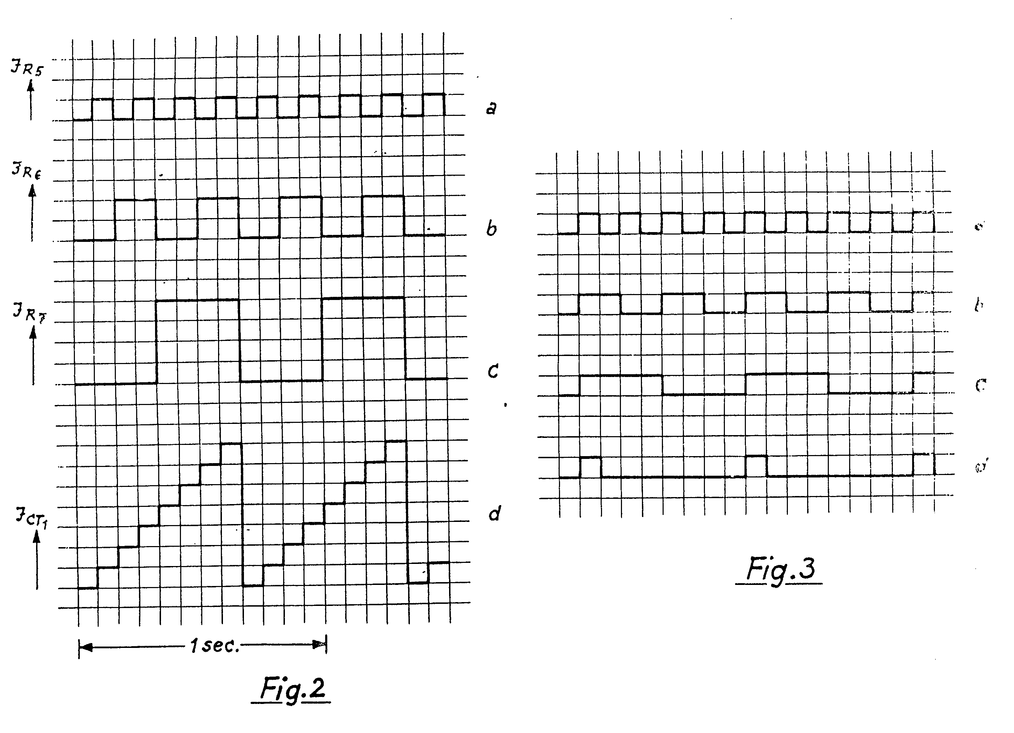

Diese Schwierigkeit konnte jedoch durch eine überraschend einfache und zweckmässige Schaltungsergänzung überwunden werden, welche die Verwendung des beschriebenen einfachen und kostengünstigen Digitaloszillators erst ermöglichte. Sie besteht darin, dass ein npn-Transistor $T_1$ mit seiner Basis über einen Widerstand $R_4$ an den Ausgang des ersten Inverters $I_1$ und mit seinem Emitter an den gemeinsamen Punkt der Widerstände $R_1$ bis $R_3$ und des Kondensators $C_1$ angeschlossen wird. Das Wobbelsignal gelangt über den Kollektor dieses Transistor $T_1$ in den Oszillator 1. Der Transistor $T_1$ ist nur so lange leitend, als das Ausgangspotential des Inverters $I_2$ auf L liegt, wobei sich dann der Kollektorstrom und der Strom durch die Widerstände $R_2$ parallel $R_3$ addieren und durch die veränderte Aufladezeit des Kondensators $C_1$ die erwünschte Frequenzbeeinflussung bewirken. Je grösser der Kollektorstrom ist, um so schneller wird der Kondensator aufgeladen und um so grösser ist damit die Frequenz des Signals am Ausgang des Oszillators 1. Dieses Oszillatorsignal mit einer Grundfrequenz von 3,072 Hz durchläuft nun insgesamt elf binäre Frequenzteiler $FT_1$ bis $FT_{11}$. Die Signale nach dem 9., 10. und 11. Frequenzteiler, mit den Frequenzen 6 Hz, 3 Hz und 1,5 Hz werden über je einen Widerstand $R_5$, $R_6$, sowie $R_7$, deren Werte sich wie 4:2:1 verhalten, ausgekoppelt und über je eine dazu in Reihe geschaltete Diode $D_1$, $D_2$ und $D_3$ am Kollektor des Oszillatortransistors $T_1$ angeschlossen. Der Kollektorstrom $I_{CT1}$ weist dadurch den in Figur 2 dargestellten, aus der Addition der Teilströme $I_{R5}$ bis $I_{R7}$ entstandenen treppenförmigen Verlauf mit einer Frequenz von 1,5 Hz auf. Diese Wobbel-Frequenz hat sich hinsichtlich der Signalwirkung des Ausgangssignals als günstiger Kompromiss zwischen zu langsamer und zu schneller Änderung der Tonfrequenz erwiesen.

Die Unterteilung der Treppe in $2^3$ Stufen durch die Addition dreier Signale mit jeweils halbierter Frequenz einerseits und der auf Grund des genannten Widerstandsverhältnisses erzielte gleichmässig ansteigende Verlauf ergeben ein sehr eindringliches und auffälliges Signal, bei dem die Stufen der Treppe gerade nicht mehr hörbar sind. Die bereits weiter oben beschriebene, in Figur 2 nicht dargestellte Verringerung der Stufenbreite zu höheren Strömen hin, stellt keinen Nachteil dar, sondern bewirkt im Gegenteil, wie sich aus einer Reihe von Versuchen ergeben hat, sogar eine Verstärkung der subjektiv empfundenen Signalwirkung.

Die Dioden $D_1$ bis $D_3$ dienen einerseits dem Schutz des Transistors $T_1$, weil sie eine negative Kollektor-Emitterspannung verhindern und sorgen zum anderen in vorteilhafter Weise dafür, dass die Teilströme $I_{R5}$ bis $I_{R7}$ vollständig zum Kollektor des Transistors $T_1$ gelangen. Für die Bedürfnisse der Praxis genügt es allerdings in vielen Fällen, lediglich eine einzige Schutzdiode am Kollektor vorzusehen und die Aufteilungen der Teilströme an den Verknüpfungspunkten der Widerstände $R_5$, $R_6$ und $R_7$ durch entsprechende Änderung ihres Widerstandsverhältnisses auszugleichen.

Das Ausgangssignal zur Speisung des Lautsprechers 4 über eine NF-Verstärker 3 wird bei dem hier beschriebenen Ausführungsbeispiel dadurch erzeugt, dass zusätzlich zu dem Signal am Ausgang des Frequenzteilers $FT_3$, an dem die gewünschte Tonfrequenz (384 Hz) zur Verfügung steht, auch die Signale an den Ausgängen der unmittelbar vorgeschalteten Frequenzteiler $FT_1$ und $FT_2$ entnommen und auf die drei Eingänge eines Und-Gatters 2 eingespeist werden, welches aus drei in den Eingangszweigen liegenden, anodenseitig auf den Ausgang geschalteten Dioden $D_4$, $D_5$, $D_6$, sowie einem Widerstand $R_8$ zwischen dem Speisespannungsanschluss $U_B$ und dem Ausgang besteht.

Durch diesen Kunstgriff ist der Vorteil erreicht, dass das Tastverhältnis des Ausgangssignals den für die hier benutzte Tonfrequenz optimalen Wert von 1:7 aufweist. Dabei wird die Lautsprechermembrane gerade zum Vollausschlag gebracht, aber keine unnötige Energie durch Aufrechterhaltung dieses Vollausschlages verbraucht. Der Grund dafür, dass der erste Eingang des Und-Gatters 2 nicht direkt am Ausgang des Oszillators 1 angeschlossen ist, liegt darin, dass für die vorstehend beschriebene Erzeugung des Ausgangssignals die Teilsignale ein Tastverhältnis 1:1 haben müssen, von dem das Oszillatorsignal abweicht, weil die Aufladung des Kondensators $C_1$ schneller vor sich geht als seine Entladung. Am Ausgang des ersten Frequenzteilers steht das gewünschte Tastverhältnis dagegen notwendigerweise zur Verfügung.

Zur Anhebung des Ausgangssignalpegels auf einen für den Lautsprecher 4 günstigen Wert ist ein zweistufiger Verstärker 3 vorgesehen, bei dem der Widerstand $R_9$ den Basisstrom für den Transistor $T_3$ liefert, der Widerstand $R_{10}$ bei gesperrtem Transistor $T_2$ einen Kollektorstrom im Transistor $T_3$ verhindert und die Diode $D_7$ den Transistor $T_3$ vor Spannungsspitzen des Lautsprechers 4 schützt.

**Patentansprüche**

1. Akustischer Signalgeber mit periodisch sich ändernder Frequenz des Ausgangssignals, bei dem zum Erzeugen des Ausgangssignals nur ein einziger Oszillator vorgesehen ist, dessen Grundsignal durch ein niederfrequentes Wobbel-Signal veränderbar ist, dadurch gekennzeichnet, dass das Wobbel-Signal aus dem Oszillator mittels an sich bekannter digitaler Frequenzteiler gewonnen wird.

2. Akustischer Signalgeber nach Anspruch 1, dadurch gekennzeichnet, dass als Oszillator ein an sich bekannter, ein Rechtecksignal erzeugender Digital-Oszillator (1) vorgesehen ist und das Wobbel-Signal über einen Widerstand $(R_7)$ vom Ausgang des letzten Frequenzteilers $(FT_{11})$ an den Kollektor eines Transistors $(T_1)$ gelangt, dessen Emitter am Eingang und dessen Basis über einen Widerstand $(R_4)$ am Ausgang eines ersten Inverters $(I_1)$ des Digital-Oszillators (1) angeschlossen ist.

3. Akustischer Signalgeber nach Anspruch 2, dadurch gekennzeichnet, dass in Serie zu dem Widerstand $(R_7)$ eine Diode $(D_3)$ und zwischen dem Eingang des ersten Inverters $(I_1)$, sowie dem gemeinsamen Verbindungspunkt des Transistoremitters, sowie eines frequenzbestimmenden Widerstandes $(R_2)$ und eines Kondensators $(C_1)$ im Digital-Oszillator (1) ein Schutzwiderstand $(R_1)$ eingeschaltet ist.

4. Akustischer Signalgeber nach Anspruch 2 oder 3, dadurch gekennzeichnet, dass dem frequenzbestimmenden Widerstand $(R_2)$ ein Abgleichswiderstand $(R_3)$ parallel geschaltet ist.

5. Akustischer Signalgeber nach einem der Ansprüche 2 bis 4, dadurch gekennzeichnet, dass ein oder mehrere zusätzliche Widerstände $(R_5, R_6)$ zwischen Verbindungspunkten je zweier benachbarter Frequenzteiler $(FT_9/FT_{10}, FT_{10}/F_{11})$ und dem Kollektor des Transistors $(T_1)$ eingeschaltet sind.

6. Akustischer Signalgeber nach Anspruch 5, dadurch gekennzeichnet, dass den zusätzlichen Widerständen $(R_5, R_6)$ je eine Diode $(D_1, D_2)$ in Reihe geschaltet ist.

7. Akustischer Signalgeber nach einem der Ansprüche 1 bis 6, dadurch gekennzeichnet, dass die Signale zwischen mehreren aufeinanderfolgenden Frequenzteilern $(FT_1/FT_2, FT_2/FT_3, FT_3/FT_4)$ mittels eines «Und»-Gatters (2) als Ausgangssignal zusammengefasst und einem Lautsprecher (4) zugeführt sind.

**Claims**

1. Acoustic signal generator with periodically changing output-signal frequency in which provided to generate the output signal is only one single oscillator (1), the basic signal of which is variable by a low-frequency sweep signal, wherein the sweep signal is obtained from the oscillator (1) by means of known digital frequency dividers ($FT_1 ... FT_{11}$).

2. Acoustic signal generator as defined in Claim 1, wherein a known digital oscillator (1) generating a square-wave signal is provided as oscillator and said sweep signal travels from the output of the last frequency divider ($FT_{11}$) via a resistor ($R_7$) to the collector of a transistor ($T_1$), the emitter of which is connected to the input, and the base of which is connected via a resistor ($R_4$) to the output of a first inverter ($I_1$) of said digital oscillator (1).

3. Acoustic signal generator as defined in Claim 2, wherein a diode ($D_3$) is connected in series to the resistor ($R_7$), and a protective resistor ($R_1$) is connected between the input of said first inverter ($I_1$) and the common connection point of said transistor emitter, a frequency-determining resistor ($R_2$) and a capacitor ($C_1$) in said digital oscillator (1).

4. Acoustic signal generator as defined in Claims 2 and 3, wherein a balancing resistor ($R_3$) is parallel-connected to said frequency-determining resistor ($R_2$).

5. Acoustic signal generator as defined in one of Claims 2 to 4, wherein one or more additional resistors ($R_5$, $R_6$) is connected in each case between connection points of two adjacent frequency dividers ($FT_9/FT_{10}$, $FT_{10}/FT_{11}$) and said collector of said transistor ($T_1$).

6. Acoustic signal generator as defined in Claim 5, wherein a diode ($D_1$, $D_2$) is series-connected in each case to each of said additional resistors ($R_5$, $R_6$).

7. Acoustic signal generator as defined in one of Claims 1 to 6, wherein the signals between several successive frequency dividers ($FT_1/FT_2$, $FT_2/FT_3$, $FT_3/FT_4$) are combined into an output signal by means of an AND gate (2) and conducted to a loudspeaker (4).

**Revendications**

1. Circuit générateur de son audible dont la fréquence du signal de sortie change périodiquement, un seul oscillateur (1) étant prévu pour la génération du signal de sortie et le signal de base de cet oscillateur pouvant être modifié par un signal de vobbulation basse fréquence, caractérisé par le fait que celui-ci est obtenu à partir de cet oscillateur au moyen des diviseurs de fréquence numériques ($FT_1...FT_{11}$).

2. Circuit générateur de son audible suivant la revendication 1, caractérisé par le fait que l'on a prévu un oscillateur (1) de type connu, à savoir un oscillateur numérique produisant un signal rectangulaire, et que le signal de vobbulation passe par une résistance ($R_7$) située à la sortie du dernier diviseur de fréquence ($FT_{11}$) avant d'arriver au collecteur d'un transistor ($T_1$) dont l'émetteur est raccordé à l'entrée et la base, par une résistance ($R_4$), à la sortie d'un premier inverseur ($I_1$) de l'oscillateur numérique (1).

3. Circuit générateur de son audible suivant la revendication 2, caractérisé par le fait qu'une diode ($D_3$) est montée en série avec la résistance ($R_7$) et qu'une résistance de protection ($R_1$) est branchée entre l'entrée du premier inverseur ($I_1$) et le point de jonction commun de l'émetteur du transistor, d'une résistance ($R_2$) déterminant la fréquence et d'un condensateur ($C_1$) de l'oscillateur numérique (1).

4. Circuit générateur de son audible suivant la revendication 2 ou 3, caractérisé par le fait qu'une résistance de compensation ($R_3$) est branchée en parallèle avec la résistance ($R_2$) déterminant la fréquence.

5. Circuit générateur de son audible suivant l'une des revendications 2 à 4, caractérisé par le fait qu'une ou plusieurs résistances supplémentaires ($R_5$, $R_6$) sont systématiquement branchées entre les points de jonction de deux diviseurs de fréquence voisins ($FT_9/FT_{10}$, $FT_{10}/FT_{11}$) et le collecteur du transistor ($T_1$).

6. Circuit générateur de son audible suivant la revendication 5, caractérisé par le fait qu'une diode ($D_1$, $D_2$) est branchée en série avec chacune des résistances supplémentaires ($R_5$, $R_6$).

7. Générateur de son audible suivant une des revendications 1 à 6, caractérisé par le fait que les signaux passant entre plusieurs diviseurs de fréquence consécutifs ($FT_1/FT_2$, $FT_2/FT_3$, $FT_3/FT_4$) sont réunis à l'aide d'un circuit ET (2) en un signal de sortie et acheminés vers un haut-parleur (4).

*Fig.1*

0 011 713

Fig.2

Fig.3